# EUROPEAN PATENT APPLICATION

(11) **EP 2 228 683 A1**
(43) Date of publication of application: **15.09.2010**
(21) Application number: 10155572.0
(22) Date of filing: 05.03.2010
(51) Int. Cl.: G03F 1/14

(54) **Process for Producing Pellicle**

(30) Priority: 11.03.2009 JP 2009057389
(71) Applicant: Shin-Etsu Chemical Co., Ltd., Chiyoda-ku, Tokyo (JP)
(72) Inventor: Shirasaki, Toru, Annaka-shi Gunma (JP)
(74) Representative: Vossius & Partner

(57) **Abstract**

There is provided a process for producing a pellicle, the process including a step of irradiating a pellicle film comprising a fluorine resin with UV light having a wavelength of no greater than 220 nm. There is also provided a preferred step of irradiating the pellicle film with UV light having a wavelength of no greater than 220 nm by means of at least one UV light source selected from a group consisting of a low-pressure mercury lamp, a deuterium lamp, a xenon excimer lamp, and ArF excimer laser light.

## Description

The present invention relates to a process for producing a pellicle and a pellicle.

Conventionally, in the production of a semiconductor device such as an LSI or a VLSI, or the production of a liquid crystal display panel, a method in which a pattern is formed by irradiating a semiconductor wafer or a liquid crystal substrate with light is employed. In this case, if debris is attached to the exposure master plate used here, since the debris absorbs light or reflects light, there are problems that the replicated pattern is deformed, or the edge becomes rough to thus impair the dimensions, quality, appearance, etc., resulting in a decrease of performance and the manufacturing yield of semiconductor devices or liquid crystal display panels.

For this reason, there is employed a method in which a pellicle that allows exposure light to easily pass through is adhered to the surface of the exposure master plate to act as a debris shield. In this case, the debris does not attach directly to the surface of the exposure master plate but becomes adhered to the pellicle film. Therefore, the advantage is that during lithography, the debris on the pellicle film does not become involved in the replication due to the defocus provided that the focus is set onto the pattern of the exposure master plate.

The pellicle has a constitution in which a transparent pellicle film made of nitrocellulose, cellulose acetate, a fluorine-based polymer, etc., which allows exposure light to easily pass through, is adhered on an upper part of a pellicle frame made of aluminum, etc. by means of an adhesive, while on the lower part of the pellicle frame is formed a pressure-sensitive adhesive layer comprising an acrylic resin or a silicone resin, etc. (ref. Japanese unexamined patent application publication No. 58-219023, U.S. Pat. No. 4,861,402, Japanese examined patent application publication No. 63-27707 and Japanese unexamined patent application publication No. 7-168345).

In recent years, lithography resolutions have been gradually increasing, and therefore the employed light sources are slowly shifting to shorter wavelengths to realize such resolutions. Specifically, there is a shift towards g-line (436 nm), i-iine (365 nm), and KrF excimer lasers (248 nm) in UV light, while recently ArF excimer lasers (193 nm) have begun to be used.

Particularly when ArF laser light is used as exposure light, a growing foreign matter may be formed on the pattern surface of the mask. This is considered to be due to the solid deposition formed on the mask surface by the reaction between ArF laser light and gaseous organic or inorganic compounds present in the environment in which the mask is placed. There is also considered a case that a washing residue (mostly, ionic species in this case) which is formed during washing of the mask remains on the mask, and this remaining ionic species may react upon exposure to ArF laser light to also give the solid deposition on the mask surface. The occurrence of the deposition of the foreign matter on the pattern may cause serious defects because the image of the foreign matter can be printed on the wafer. Therefore, several approaches are being taken to control the concentration of gaseous organic or inorganic species in the environment in which the mask is used or reduce the washing residue.

The above-mentioned deposition of foreign matter may occur on the reverse side of the mask pattern (usually called the "glass face"), or on the pellicle film. In this case, the image of the deposited foreign matter on the glass is not printed to the wafer because it is defocused by the thickness of the mask. Nor the image of the deposited foreign matter on the pellicle film is printed to the wafer because the image is defocused by the distance between the pellicle film and the pattern surface.

However, the deposited foreign matters on the glass face or on the pellicle film cause exposure light to scatter, resulting in a decrease in transmittance of the mask. The decreased transmittance of the mask leads to a corresponding decreased amount of light reaching the wafer which causes increased line-width variation of the pattern formed on the wafer, resulting in a quality loss of the semiconductor element.

It is an object of the present invention to provide a pellicle whose degradation in transmittance after a long time use is reduced.

The above-mentioned object of the present invention has been attained by means (1) and (10) below, which are described together with preferred embodiments (2) to (9).
(1) A process for producing a pellicle, the process comprising: a step of irradiating a pellicle film comprising a fluorine resin with UV light having a wavelength of no greater than 220 nm,
(2) the process for producing a pellicle according to (1), wherein the process comprises, in order: a step of forming a pellicle film comprising a fluorine resin on a substrate; a step of peeling off the pellicle film from the substrate; and a step of irradiating the pellicle film with UV light having a wavelength of no greater than 220 nm,
(3) the process for producing a pellicle according to (1) or (2), wherein the step of irradiating with UV light is a step of irradiating with UV light comprising light having a wavelength of 185 nm by means of a low-pressure mercury lamp,
(4) the process for producing a pellicle according to (1) or (2), wherein the step of irradiating with UV light is a step of irradiating with UV light comprising light having a wavelength of at least 160 nm but no greater than 220 nm by means of a deuterium lamp,
(5) the process for producing a pellicle according to (1) or (2), wherein the step of irradiating with UV light is a step of irradiating with UV light by means of a xenon excimer lamp,
(6) the process for producing a pellicle according to (1) or (2), wherein the step of irradiating with UV light is a step of irradiating with ArF excimer laser light,
(7) the process for producing a pellicle according to any one of (1) to (6), wherein the irradiation intensity of UV light irradiation in the step of irradiating with UV light is at least 0.1 µW/cm² but no greater than 20 mW/cm²,
(8) the process for producing a pellicle according to any one of (1) to (7), wherein in the step of irradiating with UV light, both sides of the pellicle film are irradiated with UV light.
(9) the process for producing a pellicle according to any one of (1) to (8), wherein at least 80 wt % of the pellicle film is a fluorine resin,
(10) a pellicle obtainable by the process for producing a pellicle according to any one of (1) to (9).

According to the present invention, there is provided a pellicle whose degradation in transmittance after a long time use is reduced.

The process for producing a pellicle of the present invention comprises a step of irradiating a pellicle film comprising a fluorine resin with ultraviolet light (UV light) having a wavelength of no greater than 220 nm.

The present inventors have found that, by irradiating a pellicle film comprising a fluorine resin with UV light having a wavelength of no greater than 220 nm, it becomes difficult for foreign matter to be deposited on the pellicle film, and the present invention has thus been accomplished.

The present invention is explained in detail below.

A pellicle film comprising a fluorine resin is generally produced by being formed on a smooth and clean substrate, and subsequently peeled off from the substrate. The film is affixed to a pellicle frame, and an adhesive layer is formed on the opposite side of the frame, thus completing a pellicle. After the pellicle film is peeled off from the substrate, it is preferable to irradiate this pellicle film with UV light having a wavelength of no greater than 220 nm. The step of irradiating a pellicle film with UV light having a wavelength of no greater than 220 nm may be carried out for a pellicle film on a substrate, but from the viewpoint of modifying both sides of the film by irradiating both sides of the film with UV light, it is preferable to carry out the step after the pellicle film is peeled off from the substrate. By irradiating the pellicle film with UV light having a wavelength of no greater than 220 nm, it becomes difficult for foreign matter to be deposited on the pellicle film when the pellicle is used in exposure device.

If there is no foreign matter deposited on the pellicle film, scattering by foreign matter does not occur, and degradation of transmittance can be prevented. Although the detailed mechanism of action of this phenomenon is unclear, it is surmised that by irradiating a pellicle film comprising a fluorine resin with UV light having a wavelength of no greater than 220 nm, the surface of the fluorine resin is modified, and even if gas and so on that are the source of foreign matter adsorb on the pellicle film surface they are prevented from growing into foreign matter on the pellicle film.

With regard to the UV light sources for UV light irradiation of the pellicle film, UV light sources emitting UV light having a wavelength of no greater than 220 nm can be used. Specific examples thereof include a low-pressure mercury lamp emitting light with a wavelength of 185 nm, a deuterium lamp emitting light with wavelengths of 160 to 200 nm, an excimer lamp such as a xenon excimer lamp emitting light with a wavelength of 172 nm and an ArF excimer laser emitting light with a wavelength of 193 nm.

More specifically, in the present invention, the preferred step of irradiating the pellicle film with UV light having a wavelength of no greater than 220 nm is a step of irradiating the pellicle film with UV light having a wavelength of no greater than 220 nm by means of at least one UV light source selected from a group consisting of a low-pressure mercury lamp, a deuterium lamp, a xenon excimer lamp, and an ArF excimer laser.

A low-pressure mercury lamp means a light source having the mercury vapor pressure of about 1 to 10 Pa during operation and main UV light emission at 184.9 nm and 253.7 nm. UV light with a wavelength of 185 nm is emitted when UV light is emitted using a low-pressure mercury lamp.

A deuterium lamp means a hydrogen discharge tube charged with deuterium and it exhibits a continuous spectrum over the UV wavelength range (160 nm to 400 nm). In the present invention, light with the wavelength of 100 nm to 200 nm is irradiated using a deuterium lamp as a UV light source.

Excimer laser is a device that generates laser light by means of a noble gas and a mixed gas of a halogen gas, etc., and transmits a specific pulse depending on the used gas such as noble gas and mixed gas.

UV light with a wavelength of 172 nm is emitted from a xenon excimer lamp, and UV light with a wavelength of 193 nm is emitted from an ArF excimer laser.

Examples of the UV lamp include, but are not particularly limited to, a low-pressure mercury lamp, a deuterium lamp, a xenon excimer lamp and an ArF excimer laser which are all mentioned above and are preferable from the viewpoint of easy availability. Among them, a low pressure mercury lamp and a xenon excimer lamp are particularly preferable from the viewpoint that they can irradiate a large area at a time.

The intensity of the UV light is preferably, but not particularly limited to, 0.1 µW/cm² to 20 mW/cm² This range is preferable since the effect of UV light irradiation is prominent when the irradiation intensity is in the range.

The irradiation time of the UV light is not particularly limited, but the effects are saturated after a certain amount of irradiation time. Furthermore excess irradiation with UV light may lead to degradation of the film. Therefore, the irradiation time of the UV light is preferably shorter as long as it is effective from the viewpoint of preventing the film degradation and facilitating the manufacture.

In the actual manufacturing process of a pellicle, preferably the intensity and the irradiation time of the UV light are set by, for example, determining the irradiation time on the basis of a preliminary measurement of the time when the effects become saturated, or by adjusting the intensity of the UV light after a target irradiation time having been set.

A pellicle is generally manufactured using the following steps. That is, a solution of a resin constituting a pellicle film is dropped on a substrate with a smooth surface, and a liquid film is formed. The liquid film is dried so as to form a film consisting of the resin itself and only the resin film is peeled off from the substrate for use as a pellicle film. The peeled pellicle film is affixed to an aluminum frame coated with an adhesive, a pressure-sensitive adhesive, etc. and the unnecessary film on the outside of the frame is cut off, thus a pellicle being completed.

The process for producing a pellicle preferably comprises, in order, (1) a step of forming a pellicle film comprising a fluorine resin on a substrate, (2) a step of peeling off the pellicle film from the substrate, and a step of irradiating the pellicle film with UV light having a wavelength of no greater than 220 nm.

The individual steps will now be described below in detail.

### (1) A step of forming a pellicle film comprising a fluorine resin on a substrate

### (Fluorine resin)

A pellicle film in the present invention comprises a fluorine resin. The pellicle film preferably contains a fluorine resin as its main component. Specifically, preferably at least 80 wt % of the pellicle film after coating and drying is a fluorine resin, more preferably at least 90 wt % of the pellicle film is a fluorine resin, and yet more preferably the pellicle film consists of only a fluorine resin.

Examples of the fluorine resin include, but are not particularly limited to, a perfluoroether polymer having a cyclic structure (product name: Cytop CTX-S manufactured by Asahi Glass Co. Ltd.) or a copolymer of tetrafluoroethylene and a fluorine-containing monomer having a cyclic perfluoroether group (product name: Teflon AF1600 manufactured by DuPont).

The fluorine resin may be a copolymer of a fluorine-containing monomer and other monomer(s).

### (Substrate)

A substrate on which a pellicle film is formed (film-forming substrate for forming a pellicle film comprising a fluorine resin thereon) may be selected appropriately from the known substrates if they have a certain degree of rigidity, and a flat and smooth surface. For example, there are suitably used various kinds of glass plates such as blue plate glass and quartz glass, and a single crystal silicon wafer used in the manufacture of semiconductor devices.

### (Process for producing pellicle film)

A pellicle film can be formed on the substrate using various known processes. In general, there is preferably used a process in which the resin is dissolved in a solvent in which it has a good solubility to form a resin solution, which is coated on a film-forming substrate using an existing coating method such as a spin coating method, a spray coating method or a bar coating method, and then the solvent is removed. Among them, a spin coating method is particularly preferable since it excels in controlling the thickness of the thin film to give a uniform thin film.

The resin solution coated on the film-forming substrate using a spin coating method, etc. is preferably heated together with the film-forming substrate as a whole in a clean oven, etc. to evaporate the solvent, and is allowed to dry. Thus, a fluorine-containing resin film (pellicle film) is formed.

The thickness of the pellicle film is not particularly limited, but preferably is 0.1 to 20 µm. While the pellicle film is preferably thinner from the viewpoint of maintaining a high transmittance, it is required to have a certain thickness from the viewpoint of maintaining strength. Therefore, in the case of a pellicle of 6 inches in size which is common among pellicles for semiconductor manufacture, the thickness of the pellicle film is preferably 0.2 to 2 µm, and in the case of a larger pellicle for liquid crystal display, the thickness is preferably 1 to 10 µm.

The above range is preferable because the pellicle film has excellent transmittance and strength when the thickness thereof is in this range.

### (2) A step of peeling the pellicle film from the substrate

Examples of the step of peeling the pellicle from the substrate, are not particularly limited as long as the pellicle film is peeled without any damage, and include the process of obtaining a self-supporting film, in which a resin-made frame support is affixed to the end face of the pellicle by means of a tape or etc. and the frame is lifted up to peel off the pellicle film from the film-forming substrate and to obtain a self-supporting film.

In the present invention, a pellicle can be prepared by affixing a pellicle film to a pellicle frame described below.

### (Pellicle frame)

A pellicle used in the present invention is designed as appropriate according to the shape of the mask. Generally a pellicle frame is annular, rectangular, or square in shape, and has an area and shape to cover the circuit pattern on the mask. The rectangular or square pellicle frame may have round corners. The height of the pellicle frame is generally about 1 to 10 mm, and preferably about 3 to 7 mm. Examples of a suitably used material thereof include a metal such as aluminum and a resin, etc.

There may be provided pressure-sensitive adhesives, etc. on the inner surface of the pellicle frame to adhere dust, etc. When the pellicle is fixed to the mask, there may be provided a communicating hole on the pellicle frame to eliminate the difference of atmospheric pressure between inside and outside of the hermetically sealed space formed by the pellicle and the mask, and there may be also provided a filter, etc. to prevent dust from entering through the communicating hole.

### (Pellicle)

The fluorine-containing resin film formed according to the film-forming process of the present invention is affixed onto the pellicle frame as a pellicle film using an adhesive, etc. to give a pellicle. On the end face of the pellicle frame to the opposite face where the pellicle film is affixed, there are provided an adhesive or a double-sided pressure-sensitive tape, etc. to fix the pellicle on the mask and, in addition, a protective film for protecting the adhesive or the double-sided pressure-sensitive tape, etc. Then the pellicle is put in a special case and stored until use in a photolithography process.

Furthermore, the pellicle produced by the process of the present invention is suitably used for the exposure device for manufacturing a semiconductor device or liquid display panel.

### Examples

Specific examples of the present invention are shown, but the present invention is not limited thereto.

### (Example 1)

A 4% solution of Cytop CTX-S (Asahi Glass Co., Ltd.) dissolved in perfluorotributylamine was dropped on a silicon wafer and spread over the wafer by rotating the wafer at 760 rpm by a spin coating method. Subsequently, drying was carried out at room temperature for 30 minutes and then at 180°C, thus giving a uniform film. An aluminum frame support coated with an adhesive was affixed thereto, and only the film was peeled off, thus giving a pellicle film. This pellicle film was irradiated with light from a low-pressure mercury lamp at an irradiation intensity of 20 mW/cm² for 1 minute.

An upper face of an aluminum frame (outer dimensions: 149 mm × 122 mm × 5.8 mm) whose surface had been anodized was coated with a film adhesive and a lower face thereof was coated with a mask pressure-sensitive adhesive. Subsequently, the pellicle film was affixed to the film adhesive side, and the film on the outer periphery of the frame was cut, thus completing a pellicle. When the transmittance of the pellicle film was measured, it was found to be 99.8% for a wavelength of 193 nm.

The spot size in the transmittance measurement was 6 mmφ, and if foreign matter occurred in the measurement spot, the transmittance would decrease.

This pellicle was affixed to a photomask, and this photomask equipped with the pellicle was stored in a hermetically sealed chamber having inner dimensions of 200 mm long and wide and 100 mm high. 0.2 g of a silicone resin was enclosed in this hermetically sealed chamber. After being allowed to stand for 1 week, the photomask was taken out, the pellicle was peeled off from the photomask, and when the pellicle film was examined using focused light in a dark room, deposition of foreign matter was not observed. Furthermore, when the transmittance of the pellicle film was measured, it was found to be 99.8% for a wavelength of 193 nm, and no change in transmittance was observed.

### (Example 2)

A 4% solution of Cytop CTX-S (Asahi Glass Co., Ltd.) dissolved in perfluorotributylamine was dropped on a silicon wafer and spread over the wafer by rotating the wafer at 760 rpm by a spin coating method. Subsequently, drying was carried out at room temperature for 30 minutes and then at 180°C, thus giving a uniform film. An aluminum frame support coated with an adhesive was affixed thereto, and only the film was peeled off, thus giving a pellicle film. This pellicle film was irradiated with light from a deuterium lamp at an irradiation intensity of 1 µW/cm² for 10 seconds.

An upper face of an aluminum frame (outer dimensions: 149 mm × 122 mm × 5.8 mm) whose surface had been anodized was coated with a film adhesive and a lower face thereof was coated with a mask pressure-sensitive adhesive. Subsequently, the pellicle film was affixed to the film adhesive side, and the film on the outer periphery of the frame was cut, thus completing a pellicle. When the transmittance of the pellicle film was measured, it was found to be 99.8% for a wavelength of 193 nm.

This pellicle was affixed to a photomask, and this photomask equipped with the pellicle was stored in a hermetically sealed chamber having inner dimensions of 200 mm long and wide and 109 mm high. 0.2 g of a silicone resin was enclosed in this hermetically sealed chamber. After being allowed to stand for 1 week, the photomask was taken out, the pellicle was peeled off from the photomask, and when the pellicle film was examined using focused light in a dark room, deposition of foreign matter was not observed. Furthermore, when the transmittance of the pellicle film was measured, it was found to be 99.8% for a wavelength of 193 nm, and no change in transmittance was observed.

### (Example 3)

A 4% solution of Cytop CTX-S (Asahi Glass Co., Ltd.) dissolved in perfluorotributylamine was dropped on a silicon wafer and spread over the wafer by rotating the wafer at 760 rpm by a spin coating method. Subsequently, drying was carried out at room temperature for 30 minutes and then at 180°C, thus giving a uniform film. An aluminum frame support coated with an adhesive was affixed thereto, and only the film was peeled off, thus giving a pellicle film. This pellicle film was irradiated with light from a xenon excimer lamp at an irradiation intensity of 1 mW/cm² for 10 seconds.

An upper face of an aluminum frame (outer dimensions: 149 mm × 122 mm × 5.8 mm) whose surface had been anodized was coated with a film adhesive and a lower face thereof was coated with a mask pressure-sensitive adhesive. Subsequently, the pellicle film was affixed to the film adhesive side, and the film on the outer periphery of the frame was cut, thus completing a pellicle. When the transmittance of the pellicle film was measured, it was found to be 99.8% for a wavelength of 193 nm.

This pellicle was affixed to a photomask, and this photomask equipped with the pellicle was stored in a hermetically sealed chamber having inner dimensions of 200 mm long and wide and 100 mm high. 0.2 g of a silicone resin was enclosed in this hermetically sealed chamber. After being allowed to stand for 1 week, the photomask was taken out, the pellicle was peeled off from the photomask, and when the pellicle film was examined using focused light in a dark room, deposition of foreign matter was not observed. Furthermore, when the transmittance of the pellicle film was measured, it was found to be 99.8% for a wavelength of 193 nm, and no change in transmittance was observed.

### (Example 4)

A 4% solution of Cytop CTX-S (Asahi Glass Co., Ltd.) dissolved in perfluorotributylamine was dropped on a silicon wafer and spread over the wafer by rotating the wafer at 760 rpm by a spin coating method. Subsequently, drying was carried out at room temperature for 30 minutes and then at 180°C, thus giving a uniform film. An aluminum frame support coated with an adhesive was affixed thereto, and only the film was peeled off, thus giving a pellicle film. This pellicle film was irradiated with ArF excimer laser light at an irradiation intensity of 1 mW/cm² for 10 seconds.

An upper face of an aluminum frame (outer dimensions: 149 mm × 122 mm × 5.8 mm) whose surface had been anodized was coated with a film adhesive and a lower face thereof was coated with a mask pressure-sensitive adhesive. Subsequently, the pellicle film was affixed to the film adhesive side, and the film on the outer periphery of the frame was cut, thus completing a pellicle. When the transmittance of the pellicle film was measured, it was found to be 99.8% for a wavelength of 193 nm.

This pellicle was affixed to a photomask, and this photomask equipped with the pellicle was stored in a hermetically sealed chamber having inner dimensions of 200 mm long and wide and 100 mm high. 0.2 g of a silicone resin was enclosed in this hermetically sealed chamber. After being allowed to stand for 1 week, the photomask was taken out, the pellicle was peeled off from the photomask, and when the pellicle film was examined using focused light in a dark room, deposition of foreign matter was not observed. Furthermore, when the transmittance of the pellicle film was measured, it was found to be 99.8% for a wavelength of 193 nm, and no change in transmittance was observed.

### (Comparative Example 1)

A 4% solution of Cytop CTX-S (Asahi Glass Co., Ltd.) dissolved in perfluorotributylamine was dropped on a silicon wafer and spread over the wafer by rotating the wafer at 760 rpm by a spin coating method. Subsequently, drying was carried out at room temperature for 30 minutes and then at 180°C, thus giving a uniform film. An aluminum frame support coated with an adhesive was affixed thereto, and only the film was peeled off, thus giving a pellicle film.

An upper face of an aluminum frame (outer dimensions: 149 mm × 122 mm × 5.8 mm) whose surface had been anodized was coated with a film adhesive and a lower face thereof was coated with a mask pressure-sensitive adhesive. Subsequently, the pellicle film was affixed to the film adhesive side, and the film on the outer periphery of the frame was cut, thus completing a pellicle. When the transmittance of the pellicle film was measured, it was found to be 99.8% for a wavelength of 193 nm.

This pellicle was affixed to a photomask, and this photomask equipped with the pellicle was stored in a hermetically sealed chamber having inner dimensions of 200 mm long and wide and 100 mm high. 0.2 g of a silicone resin was enclosed in this hermetically sealed chamber. After being allowed to stand for 1 week, the photomask was taken out, the pellicle was peeled off from the photomask, and when the pellicle film was examined using focused light in a dark room, deposition of many foreign matters having the size of about 1 µm was observed. Furthermore, when the transmittance of the pellicle film was measured, it was found to be 97.8% for a wavelength of 193 nm, and decrease in transmittance was observed.

It is believed that in Comparative Example 1, siloxane vapour was generated from the enclosed silicone resin and grew into the foreign matter, resulting in the decrease in transmittance. On the other hand, as described above, there were found no growing foreign matter in the case of the pellicles in Example 1 to 4 which had been irradiated with UV light having a wavelength of no greater than 220 nm, and therefore no decrease in transmittance was observed.

## Claims

1. A process for producing a pellicle, the process comprising:
a step of irradiating a pellicle film comprising a fluorine resin with UV light having a wavelength of no greater than 220 nm.

2. The process for producing a pellicle according to Claim 1, wherein the process comprises, in order:
a step of forming a pellicle film comprising a fluorine resin on a substrate;
a step of peeling off the pellicle film from the substrate; and
a step of irradiating the pellicle film with UV light having a wavelength of no greater than 220 nm.

3. The process for producing a pellicle according to Claim 1 or 2, wherein the step of irradiating with UV light is a step of irradiating with UV light comprising light having a wavelength of 185 nm by means of a low-pressure mercury lamp.

4. The process for producing a pellicle according to Claim 1 or 2, wherein the step of irradiating with UV light is a step of irradiating with UV light comprising light having a wavelength of at least 160 nm but no greater than 220 nm by means of a deuterium lamp.

5. The process for producing a pellicle according to Claim 1 or 2, wherein the step of irradiating with UV light is a step of irradiating with UV light by means of a xenon excimer lamp.

6. The process for producing a pellicle according to Claim 1 or 2, wherein the step of irradiating with UV light is a step of irradiating with ArF excimer laser light.

7. The process for producing a pellicle according to any one of Claims 1 to 6, wherein the irradiation intensity of UV light irradiation in the step of irradiating with UV light is at least 0.1 µW/cm² but no greater than 20 µW/cm².

8. The process for producing a pellicle according to any one of Claims 1 to 7, wherein in the step of irradiating with UV light, both sides of the pellicle film are irradiated with UV light.

9. The process for producing a pellicle according to any one of Claims 1 to 8, wherein at least 80 wt % of the pellicle film is a fluorine resin.
